# FASCICULE DE BREVET EUROPEEN

(11) **EP 1 457 101 B1**
(45) Date de publication et mention de la délivrance du brevet: **01.02.2012**
(21) Numéro de dépôt: 02805373.4
(22) Date de dépôt: 12.12.2002
(51) Int. Cl.: H05K 3/00

(54) **PROCEDE DE FABRICATION D UN MODULE MULTICOUCHES A CIRCUITS IMPRIMES A HAUTE DENSITE**
VERFAHREN ZUR HERSTELLUNG EINES MEHRSCHICHTIGEN MODULS MIT HOCHDICHTEN GEDRUCKTEN SCHALTUNGEN
METHOD FOR MAKING A MULTILAYER MODULE WITH HIGH-DENSITY PRINTED CIRCUITS

(30) Priorité: 20.12.2001 FR 0116522
(43) Date de publication de la demande: 15.09.2004
(73) Titulaire: ORGANISATION EUROPEENNE POUR LA RECHERCHE NUCLEAIRE (CERN), 1211 Geneve 23 (CH)
(72) Inventeur: DE OLIVEIRA, Rui, F-74800 Arenthon (FR)
(74) Mandataire: Gorrée, Jean-Michel
(86) Numéro de dépôt international: PCT/FR2002/004305
(87) Numéro de publication internationale: WO 2003/055288

(56) Documents cités:
- GB-A- 1 134 632
- US-A- 4 639 290
- US-A- 5 436 062
- US-A- 6 016 598
- PATENT ABSTRACTS OF JAPAN vol. 018, no. 107 (C-1169), 22 février 1994 (1994-02-22) & JP 05 301981 A (SUMITOMO METAL MINING CO LTD), 16 novembre 1993 (1993-11-16)
- PATENT ABSTRACTS OF JAPAN vol. 017, no. 313 (E-1381), 15 juin 1993 (1993-06-15) & JP 05 029768 A (HITACHI CABLE LTD), 5 février 1993 (1993-02-05)
- PATENT ABSTRACTS OF JAPAN vol. 006, no. 143 (C-117), 3 août 1982 (1982-08-03) & JP 57 065727 A (HITACHI CHEM CO LTD;OTHERS: 01), 21 avril 1982 (1982-04-21)

## Description

La présente invention concerne des perfectionnements apportés à la fabrication de modules multicouches à circuits imprimés à haute densité.

Il est connu de fabriquer des modules à circuits imprimés à haute densité - par exemple modules de type SBU ("Sequentiel Built-Up") ou HDI ("High Density Interconnected") ou encore MCML ("Multi Chips Module Laminated") - en collant, de part et d'autre d'un substrat à circuits imprimés double face, des couches additionnelles formées d'un film, notamment en polyimide, métallisé sur une face, chaque couche étant pourvue de trous métallisés pour établir des connexions traversantes entre ses propres pistes conductrices imprimées et celles du substrat ou d'un film sous-jacent voir par exemple le document US 5436062.

La fabrication de tels modules présente des difficultés.

Il est connu de percer des trous par voie chimique dans un film en polyimide (voir par exemple le document EP-A-0 832 918). Toutefois, les procédés connus actuellement conduisent à une gravure isotropique du polyimide, de sorte qu'il est très difficile de maîtriser parfaitement la forme et le diamètre des trous, et en particulier il est difficile de forer chimiquement des trous de très petit diamètre (ou micro-trous) nécessités par une grande densité de circuits et de connexions traversantes.

Or, les techniques électroniques actuelles exigent des miniaturisations toujours plus poussées, et donc des densités de circuits toujours plus élevées. Pour ce faire, il est nécessaire de pouvoir juxtaposer des micro-trous d'interconnexion au plus près les uns des autres, et donc de pouvoir contrôler de façon précise leurs dimensions transversales.

Les techniques de gravure chimique actuellement disponibles ne permettent pas de donner satisfaction sur ce point aux exigences de la pratique, et la gravure des micro-trous est aujourd'hui effectuée par des techniques physiques (plasma, laser ou photo-image) qui, certes, procurent la précision recherchée, mais qui, par contre, nécessitent l'emploi de matériels très performants et très coûteux, avec un investissement initial d'installation qui est très élevé.

Un inconvénient de la technique laser tient au fait que les micro-trous sont percés unitairement, les uns après les autres. Il en résulte un temps de fabrication considérablement accru.

Le collage de la couche additionnelle sur le substrat est effectué en utilisant des feuilles de colle solide qui, après découpage à la forme requise, sont appliquées sur la face non métallisée du film en polyimide, l'ensemble étant ensuite positionné sur le substrat, puis soumis à des conditions de température, de pression et de durée propres à obtenir la polymérisation de la colle. Or les feuilles de colle disponibles dans le commerce et utilisées à cet effet possèdent des épaisseurs importantes (par exemple typiquement de l'ordre d'au moins 0,05 mm).

Dans ces conditions, la pellicule de colle apparaissant au fond des micro-trous gravés à travers le film en polyimide pourrait certes être décapée à l'aide d'un solvant approprié. Toutefois les solvants connus pour les colles utilisées ont une action isotropique, de sorte que le décapage de la colle s'effectue sur un diamètre d'autant plus grand que le solvant aura agi plus longtemps pour percer l'épaisseur notable de la pellicule de colle. Par ce processus, il n'est pas possible d'assurer que le trou décapé dans la couche de colle aura exactement la même forme et les mêmes dimensions transversales que le trou percé à travers le film en polyimide.

L'invention vise à remédier aux inconvénients précités des techniques connues et à proposer un procédé perfectionné qui permette de fabriquer des modules multicouches à circuits imprimés à haute densité ayant une qualité et des caractéristiques identiques à ceux fabriqués par mise en oeuvre de techniques physiques (laser, plasma ou photo-image), mais avec un investissement en matériel très inférieur et donc avec un prix de revient unitaire des modules considérablement diminué, et avec en outre la possibilité d'une fabrication en chaîne continue.

A ces fins, il est proposé un procédé de fabrication de modules multicouches à circuits imprimés à haute densité qui, étant établi conformément à l'invention, se caractérise en ce qu'il comprend les étapes suivantes :
- préparer un substrat à circuits imprimés double face avec des trous traversants métallisés, ce substrat étant préparé par mise en oeuvre de techniques traditionnelles de fabrication de circuits imprimés ;
- coller intimement sur une face du susdit substrat, au moyen d'une colle époxyde liquide deux états polymérisable, une couche additionnelle formée d'un film de résine polyimide dont une face est revêtue d'une pellicule métallique, ladite couche étant collée par la face non métallisée du film ;
- décaper sélectivement ladite pellicule métallique de la couche additionnelle pour enlever le métal en des emplacements prédéterminés prévus pour les micro-trous en regard de zones métallisées sous-jacentes du substrat ;
- percer chimiquement de façon anisotropique des micro-trous traversants à travers ledit film en plongeant ledit film dans un bain statique d'une solution aqueuse d'éthylène-diamine additionnée de potasse en quantité proportionnée à l'épaisseur du film en résine polyimide et à la dimension transversale des micro-trous, à une température d'au moins 25°C, puis en rinçant avec une lessive ;
- éliminer la couche de colle apparaissant au fond des micro-trous traversant le film en y pulvérisant un solvant, de manière que les micro-trous débouchent sur les zones métallisées sous-jacentes du substrat ;
- métalliser lesdits micro-trous de manière que leur métallisation soit en contact conducteur avec les susdites zones métallisées sous-jacentes et avec la pellicule métallique extérieure de ladite couche ; et
- décaper sélectivement ladite pellicule métallique pour y former des circuits imprimés en liaison conductrice avec lesdits micro-trous métallisés.

De préférence, la gravure des micro-trous à travers le film en résine polyimide est obtenue en utilisant une solution aqueuse d'un tiers d'eau et deux tiers d'éthylène-diamine par litre, additionnée de potasse KOH. Dans ce cas, pour un litre de solution aqueuse, la potasse est présente à raison d'environ 64 g pour percer des micro-trous d'un diamètre d'environ 50 µm dans un film en résine polyimide d'une épaisseur d'environ 50 µm.

De façon avantageuse, la fixation par collage de la couche additionnelle comprend les étapes suivantes :
- encoller la face non métallisée du film en résine polyimide à l'aide d'une colle époxyde liquide deux états étendue en une couche d'épaisseur uniforme telle et faire polymériser la colle de manière telle que la couche uniforme de colle polymérisée ait une épaisseur sensiblement égale à au moins l'épaisseur des circuits imprimés présents sur la face réceptrice sur laquelle le film doit être collé ; et
- presser sous vide la couche sur la face réceptrice dans des conditions de température, de pression et de durée propres à assurer un collage uniforme de la couche.

Dans un mode de mise en oeuvre pratique, la couche additionnelle comprend un film en résine polyimide recouverte sur une face d'une pellicule en cuivre ayant une épaisseur d'au moins 5 µm de manière qu'elle présente une rigidité suffisante pour éviter son décollement sur les bords des micro-trous sous l'effet du gonflement du polyimide sous-jacent au contact de la solution aqueuse de gravure.

Pour constituer des modules à haute densité de circuits imprimés, on peut solidariser intimement deux couches additionnelles à face externe métallisée sur respectivement les deux faces du substrat initialement préparé, voire on empile plusieurs films les uns sur les autres en les traitant successivement.

Selon les dispositions prévues conformément à l'invention, le ou les films successifs sont traités par une technique de décapage chimique classique y compris pour le perçage des micro-trous dans des conditions permettant de conférer aux micro-trous les faibles dimensions (typiquement de l'ordre de 50 µm) et la forme précise qui sont requises. Or la mise en oeuvre d'une technique chimique ne nécessite qu'un investissement financier initial en matériels qui est considérablement moindre que celui nécessité par les matériels de technologies évoluées (plasma, laser, photo-image) employés jusqu'à présent aux mêmes fins. De plus, le recours à une technique chimique permet d'établir une fabrication continue à la chaîne, en lieu et place des fabrications pas par pas nécessitées par la mise en oeuvre antérieure de technologies physiques.

Autrement dit, la mise en oeuvre du procédé de l'invention permet de fabriquer des modules à haute densité de circuits imprimés à moindre coût et de façon plus rapide et plus régulière, tout en obtenant des modules de mêmes caractéristiques.

On précisera ici que, dans le cadre de la présente invention, on entend désigner par "trous ou micro-trous percés de façon anisotropique" des trous dont les dimensions transversales sont parfaitement contrôlées sur toute leur profondeur, ces dimensions transversales diminuant de façon contrôlée depuis la surface du film. Autrement dit, on cherche à réaliser des trous qui ne sont pas strictement de forme cylindrique, mais qui sont de forme conique à conicité contrôlée (par exemple avec un diamètre du fond qui est approximativement moitié du diamètre de l'orifice) afin qu'ultérieurement la métallisation desdits trous puisse être effectuée correctement, avec une couche uniforme de métal qui adhère parfaitement à la paroi des trous.

L'invention sera mieux comprise à la lecture de la description détaillée qui suit de certains modes préférés de mise en oeuvre du procédé de l'invention. Dans cette description, on se réfère aux dessins annexés sur lesquels :
- les figures 1A à 1H illustrent schématiquement diverses étapes successives d'une mise en oeuvre préférée du procédé de l'invention ; et
- les figures 2 et 3 illustrent des variantes intéressantes de modules susceptibles d'être obtenus par mise en oeuvre du procédé conforme à l'invention.

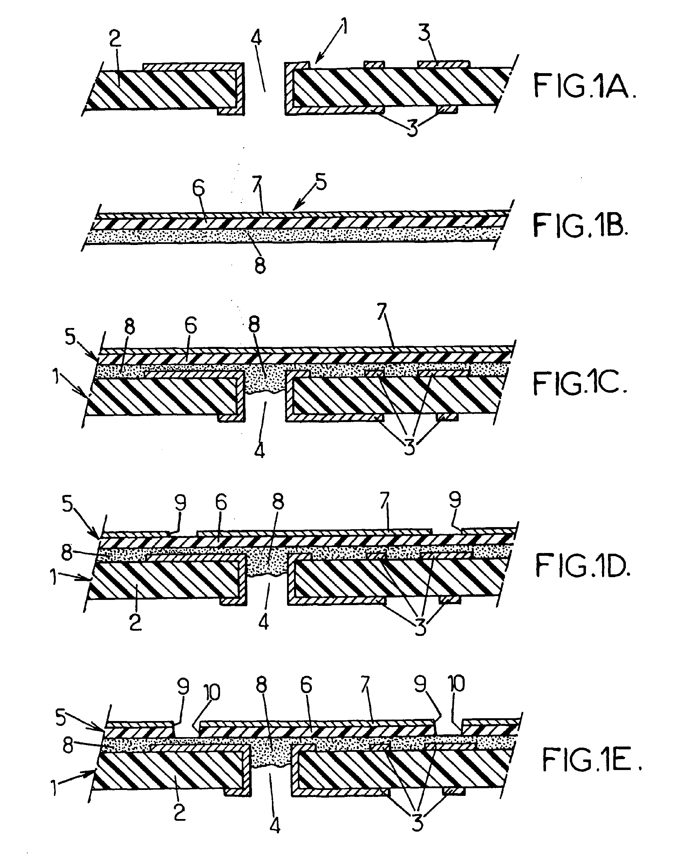

On se réfère maintenant tout d'abord aux figures 1A à 1H qui illustrent, schématiquement, les étapes principales successives du procédé de l'invention conduisant à la réalisation d'un module multicouches simple (c'est-à-dire comportant une seule couche additionnelle).

Pour mettre en oeuvre le procédé perfectionné de l'invention, on part d'un substrat 1 illustré à la figure 1A, constitué d'une plaque 2 rigide (par exemple en résine époxyde) ou semi-rigide (par exemple en résine polyimide) portant des circuits imprimés 3 (par exemple en cuivre) sur ses deux faces. Des liaisons conductrices entre des conducteurs imprimés des deux faces sont obtenues à l'aide de trous métallisés 4 obtenus classiquement par perçage mécanique de la plaque à l'aide d'un foret, puis métallisation des trous. La métallisation des trous et la fabrication des circuits imprimés sur les deux faces sont effectuées par mise en oeuvre de techniques traditionnelles dans ce domaine (notamment décapage chimique des circuits imprimés).

Pour augmenter le nombre des conducteurs imprimés, on solidarise intimement, sur une face du substrat précédemment préparé, une couche additionnelle ayant une âme formée d'un film en résine polyimide recouverte, sur une face externe, d'une pellicule métallique, en général en cuivre.

De façon plus précise, on peut procéder de la façon suivante.

Comme illustré à la figure 1B, on utilise une couche additionnelle 5 de type souple, comportant une âme formée d'un film en résine polyimide 6, tel que ceux disponibles commercialement sous les dénominations "Kapton" et "Apical" ; une face de ce film 6 est recouverte d'une pellicule métallique 7, notamment en cuivre, ayant une très faible épaisseur qui toutefois n'est pas inférieure à 5 µm pour être mécaniquement résistante et pouvoir subir les traitements ultérieurs sans décollement. Une telle couche métallisée simple face sans adhésif est couramment disponible dans le commerce (par exemple polyimide métallisé G2300 de la société SHELLDALL).

Sur la face non métallisée du film 6, on dépose une couche d'épaisseur uniforme d'une colle liquide époxy monocomposant deux états telle que celles disponibles commercialement sous les dénominations génériques FR4, G10, G11.

On fait ensuite polymériser la colle, en faisant en sorte que l'épaisseur de la couche de colle polymérisée 8 soit sensiblement égale à au moins l'épaisseur des conducteurs imprimés sur le substrat 1 (par exemple de l'ordre de 15 à 30 µm) de manière à être assuré qu'il ne subsistera ensuite aucun espace libre entre le substrat 1 et le film en polyimide 6.

On applique ensuite la couche 5 par sa face encollée sur une face du substrat 1, en la pressant sous vide sur celui-ci. A cette fin, on a recours à des équipements standards de fabrication de plaques pour circuits imprimés, en respectant les conditions de température, de pression et de durée préconisées pour le type de colle utilisé (ici colle FR4 par exemple). On obtient ainsi un ensemble bicouches tel qu'illustré à la figure 1C.

Ensuite on procède au perçage anisotropique par voie chimique de trous traversants de faible diamètre (ci-après dénommés micro-trous) à travers la couche additionnelle 5 en regard de zones métallisées prédéterminées de la face sous-jacente du substrat. Pour ce faire, on peut procéder comme il suit.

On traite la pellicule métallique 7 du film métallisé 5 par un procédé photolithographique pour imager la position du futur micro-trou dans la pellicule métallique 7, avec enlèvement du métal (en 9) auxdits emplacements, comme illustré à la figure 1D.

On effectue ensuite, à travers les emplacements 9 ouverts dans la pellicule métallique 7, une gravure anisotropique à travers le film 6 en polyimide en utilisant un bain statique d'une solution aqueuse d'éthylène-diamine additionnée de potasse, sous une température d'au moins 25°C. Les meilleurs résultats sont obtenus avec une solution contenant 1/3 d'eau et 2/3 d'éthylène-diamine additionnée d'au moins 60 g de potasse KOH par litre de solution pour percer des trous d'un diamètre de l'ordre de 50 µm dans un film en résine polyimide d'une épaisseur d'environ 50 µm. On notera que plus la température est élevée (en restant inférieure à la température d'ébullition qui est de l'ordre de 110°C pour la composition indiquée plus haut) et/ou plus la teneur en potasse est augmentée, et plus la paroi des micro-trous creusés à travers le polyimide est proche de la perpendicularité à la face du film 6.

Toutefois, comme cela a été exposé plus haut, il n'est pas souhaitable que les micro-trous soient de forme cylindrique : pour que la métallisation ultérieure de leur paroi puisse être effectuée correctement avec une bonne adhérence et une bonne régularité de la pellicule de métallisation, il est souhaitable que les micro-trous soient de forme tronconique avec une conicité contrôlée (par exemple rapport de 1 à 2 des diamètres du fond et de l'orifice). C'est l'obtention de micro-trous ayant des formes et des dimensions transversales parfaitement contrôlées que l'on entend désigner, dans le contexte de la présente, sous le terme de formation "anisotropique".

Au cours de cette étape, la résine polyimide, au contact de la solution de gravure, se gorge progressivement de liquide, de sorte qu'elle augmente localement de volume : c'est l'action de ce gonflement qui risque d'entraîner un délaminage localisé de la pellicule métallique superficielle et qui nécessite de mettre en oeuvre une pellicule d'au moins 5 µm d'épaisseur afin que celle-ci puisse, par sa résistance mécanique, s'opposer à ce soulèvement.

On rince ensuite avec une lessive appropriée pour éliminer les traces du bain de gravure et ainsi stopper la gravure. A cet effet, on peut par exemple utiliser la lessive référencée par NGL 17-40 commercialisée par la Société LEA-RONAL, diluée dans l'eau à raison de 10 g/ℓ.

On se trouve alors, comme illustré à la figure 1E, en présence de perforations 10 creusées à travers la couche de polyimide 6 et débouchant, inférieurement, en regard des susdites zones métallisées prédéterminées du substrat 1.

Toutefois, comme visible à la figure 1E, de la colle peut recouvrir les zones métallisées prédéterminées, colle qui, étant en général non conductrice électriquement, doit être éliminée. A cette fin, il faut pulvériser dans les micro-trous un solvant de la colle utilisée, la pulvérisation assurant que le nuage du solvant pénètre jusqu'au fond des micro-trous malgré la faible dimension transversale de ceux-ci.

Dans le cas de la colle époxyde monocomposante utilisée, telle que la colle FR4, on peut avantageusement pulvériser de l'acide sulfurique concentré à au moins 90%, de préférence à environ 96 % : cet acide épargne le cuivre et le polyimide, mais dissout la couche de colle dans le prolongement de la gravure de la perforation 10.

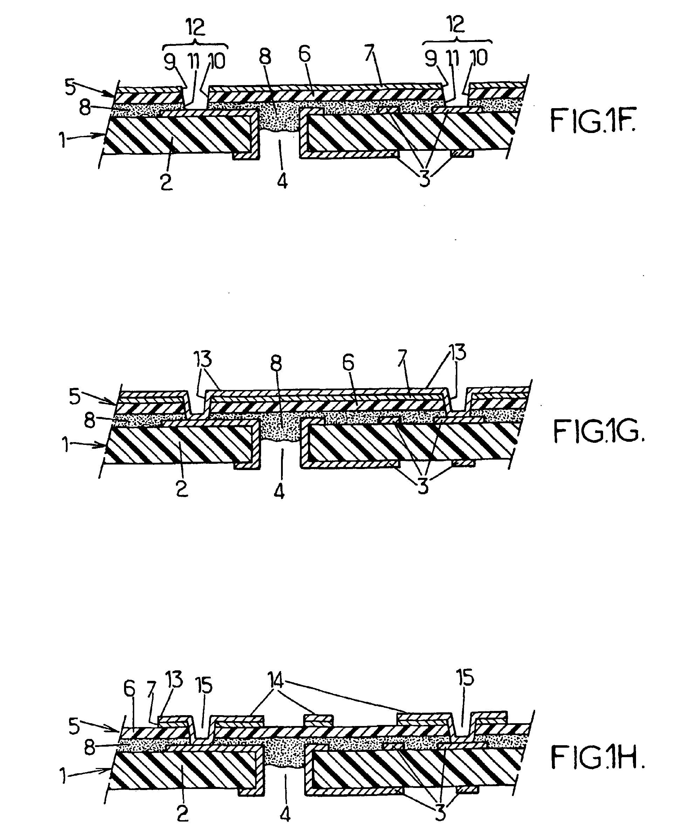

Ainsi, comme représenté à la figure 1F, l'ensemble formé par l'évidement 9 pratiqué dans la pellicule métallique superficielle 7, la perforation 10 pratiquée chimiquement dans le film en polyimide 6 et l'évidement 11 formé dans la couche de colle au contact du conducteur métallique sous-jacent du substrat 1, tous situés dans le prolongement les uns des autres, définit un trou de faible diamètre ou micro-trou 12.

On achève le module par une métallisation des micro-trous 12 et des conducteurs imprimés sur la face externe du film 5 en procédant par mise en oeuvre de procédés classiques dans le domaine des circuits imprimés. Ainsi la métallisation des micro-trous 12 peut être effectuée par dépôt sous vide d'un métal approprié (notamment du cuivre) de manière à constituer une couche métallique 13 dans les micro-trous 12 qui est en contact conducteur, d'une part, avec le fond des micro-trous constitué par le conducteur imprimé sous-jacent du substrat 1 et, d'autre part, avec la pellicule superficielle 7 du film. En pratique, le dépôt de métal est effectué sous forme d'une couche métallique 13 recouvrant l'ensemble des surfaces, comme cela apparaît à la figure 1G.

On effectue ensuite le décapage sélectif de la couche métallique superficielle (formée par les couches 7 et 13 au contact l'une de l'autre) pour constituer les pistes 14 imprimées de la face externe du film 6, pistes au contact conducteur desquelles sont situés les micro-trous métallisés 15, comme visible à la figure 1H.

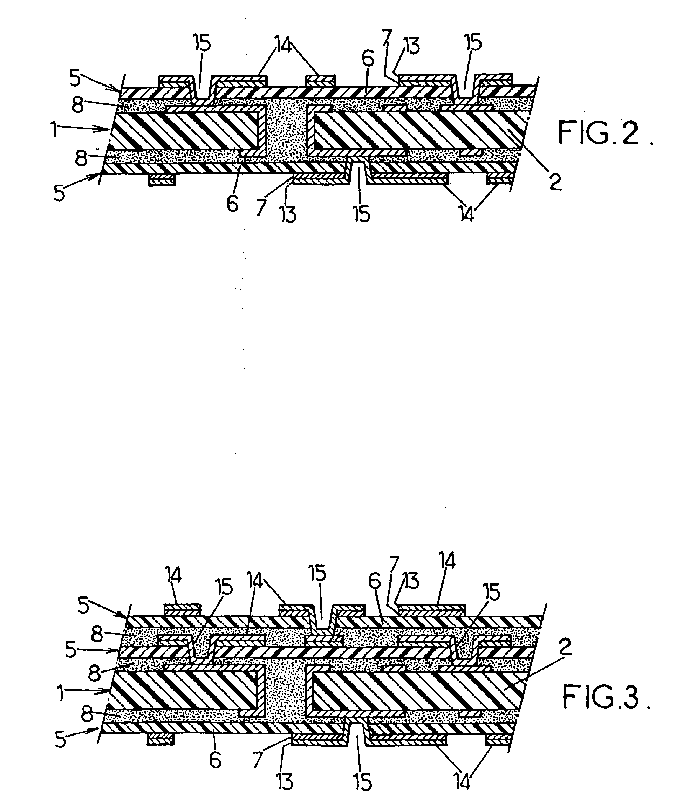

De façon préférée, on fixe sur le substrat 1 simultanément deux couches additionnelles 5 encollées, respectivement sur les deux faces dudit substrat, puis on traite simultanément ces deux couches de manière à obtenir finalement un module multicouches à quatre ensembles de circuits imprimés, comme illustré à la figure 2, des micro-trous métallisés 15 pouvant être présents sur l'une et/ou l'autre face externe du module.

On peut également envisager de superposer plusieurs couches additionnelles 5 les unes sur les autres, au fur et à mesure que le traitement de la couche sous-jacente est achevé. A la figure 3 est illustré un module construit autour d'un substrat central 1 avec l'ajout d'une couche additionnelle 5 inférieure et de deux couches additionnelles 5 supérieures superposées.

Grâce au procédé de l'invention, il est possible de fabriquer des modules multicouches à circuits imprimés à haute densité, en réalisant des micro-trous métallisés de faible diamètre (par exemple de l'ordre de 50 µm) par mise en oeuvre d'une technique de gravure anisotrope du polyimide par voie chimique. L'investissement initial en matériels étant beaucoup moins élevé que celui nécessité par des techniques physiques (laser, plasma, photo-image), le coût de fabrication des modules est notablement réduit. Ce procédé s'avère compatible avec les unités classiques de fabrication des cartes à circuits imprimés : tout fabricant de cartes à circuits imprimés classiques est ainsi en mesure de produire des modules à haute densité de circuits imprimés, ce qui jusqu'alors restait l'apanage des seules sociétés susceptibles de financer un équipement de gravure laser, plasma ou photo-image.

On notera également que le procédé de l'invention est un procédé global et que le temps de production ne dépend pas du nombre des micro-trous métallisés présents dans le module.

Enfin, on notera également que, par mise en oeuvre du procédé de l'invention, il est possible de réaliser des micro-trous métallisés ayant n'importe quelle dimension, du domaine du micron au domaine du centimètre, et n'importe quelle forme de section (ronde, polygonale, étoile, ...).

## Revendications

1. Procédé de fabrication d'un module multicouches à circuits imprimés à haute densité, comprenant les étapes suivantes :
- préparer un substrat (1) à circuits imprimés (3) double face avec des trous traversants métallisés (4), ce substrat (1) étant préparé par mise en oeuvre de techniques traditionnelles de fabrication de circuits imprimés ;
- coller intimement sur une face du susdit substrat, au moyen d'une colle (8) époxyde liquide deux états polymérisable, une couche additionnelle (5) formée d'un film de résine polyimide (6) dont une face est revêtue d'une pellicule métallique (7), ladite couche étant collée par la face non métallisée du film ;
- décaper sélectivement ladite pellicule metallique (7) de la couche additionnelle (5) pour enlever le métal en des emplacements prédéterminés prévus pour les micro-trous (12) en regard de zones métallisées sous-jacentes du substrat ; **caractérisé par** les étapes suivantes :
- percer chimiquement de façon anisotropique des micro-trous (12) traversants à travers ledit film (6) en plongeant ledit film (6) dans un bain statique d'une solution aqueuse d'éthylène-diamine additionnée de potasse en quantité proportionnée à l'épaisseur du film (6) en résine polyimide et à la dimension transversale des micro-trous (12), à une température d'au moins 25°C, puis en rinçant avec une lessive ;
- éliminer la couche de colle (8) apparaissant au fond des micro-trous (12) traversant le film (6) en y pulvérisant un solvant, de manière que les micro-trous (12) débouchent sur les zones métallisées sous-jacentes du substrat (1);
- métalliser lesdits micro-trous (12) de manière que leur métallisation soit en contact conducteur avec les susdites zones métallisées sous-jacentes et avec la pellicule métallique (7) extérieure de ladite couche (5); et
- décaper sélectivement ladite pellicule métallique (7) pour y former des circuits imprimés (14) en liaison conductrice avec lesdits micro-trous métallisés.

2. Procédé selon la revendication 1, **caractérisé en ce que** la gravure des micro-trous (12) a travers le film (6) en résine polyimide est obtenue en utilisant une solution aqueuse d'un tiers d'eau et deux tiers d'éthylène-diamine par litre, additionnée de potasse KOH.

3. Procédé selon la revendication 2, **caractérisé en ce que**, pour un litre de solution aqueuse, la potasse est présente à raison d'environ 64 g pour percer des micro-trous d'un diamètre d'environ 50 µm dans un film en résine polyimide d'une épaisseur d'environ 50 µm.

4. Procédé selon l'une quelconque des revendications 1 à 3, **caractérisé en ce que** la fixation par collage de la couche additionnelle (5) comprend les étapes suivantes :
- encoller la face non métallisée du film (6) en résine polyimide à l'aide d'une colle (8) époxyde liquide deux états étendue en une couche d'épaisseur uniforme telle et faire polymériser la colle de manière telle que la couche uniforme de colle polymérisée (8) ait une épaisseur sensiblement égale à au moins l'épaisseur des circuits imprimés (3, 14) présents sur la face réceptrice sur laquelle le film (6) doit être collé ; et
- presser sous vide la couche (5) sur la face réceptrice dans des conditions de température, de pression et de durée propres à assurer un collage uniforme de la couche (5).

5. Procédé selon l'une quelconque des revendications 1 à 4, **caractérisé en ce que** l'élimination de la couche de Colle (8) au fond des micro-trous (9, 11) est effectuée par pulvérisation d'acide sulfurique ayant une concentration de 90 à 100 %.

6. Procédé selon l'une quelconque des revendications 1 à 5, **caractérisé en ce que** la couche additionnelle (5) comprend un film (6) en résine polyimide recouvert sur une face d'une pellicule (7) en cuivre ayant une épaisseur d'au moins 5 µm.

7. Procédé selon l'une quelconque des revendications 1 à 6, **caractérisé en ce qu'**on solidarise intimement deux couches additionnelles (5) à face externe métallisée sur respectivement les deux faces du substrat (1) initialement préparé.

8. Procédé selon l'une quelconque des revendications 1 à 7, **caractérisé en ce qu'**on solidarise intimement encore au moins une autre couche additionnelle (5) sur la face externe d'une couche (5) précédemment mise en place et on renouvelle le processus de traitement sur cette autre couche.

## Claims

1. A process for fabricating a high-density printed-circuit multilayer module, comprising the following steps of:
- preparing a substrate (1) with printed circuits (3) on both sides and with metallized through-holes (4), this substrate (1) being prepared by using conventional printed-circuit fabrication techniques;
- intimately bonding, on one side of the abovementioned substrate, by means of a curable two-stage liquid epoxy adhesive (8), an additional layer (5) formed from a polyimide resin film (6), one face of which is coated with a metal coating (7), said layer being bonded via the non-metallized face of the resin film;
- selectively etching said metal coating (7) of the additional layer (5) in order to remove the metal at predetermined locations intended for the microholes (12) facing subjacent metallized regions of the substrate; **characterized by** the following steps :
- anisotropic chemical drilling of through-microholes (12) through said film (6) by immersing said film (6) in a static bath of an aqueous ethylenediamine solution to which potassium hydroxide has been added in an amount proportional to the thickness of the polyimide resin film (6) and to the transverse dimension of the microholes (12), at a temperature of at least 25°C., and then by rinsing with a detergent;
- removing the adhesive layer (8) appearing at the bottom of the microholes (12) passing through the film (6) by spraying a solvent thereon so that the microholes (12) emerge at the subjacent metallized regions of the substrate (1) ;
- metallizing said microholes (12) so that their metallization is in conducting contact with the abovementioned subjacent metallized regions and with the external metal coating (7) of said layer (5) ; and
- selectively etching said metal coating (7) in order to form printed circuits (14) thereon which are in conducting contact with said metallized microholes.

2. The process according to claim 1, **characterized in that** the microholes (12) are etched through the polyimide resin film (6) using an aqueous solution of one third water and two thirds ethylenediamine per liter, to which potassium hydroxide KOH has been added.

3. The process according to claim 2, **characterized in that**, for one liter of aqueous solution, the amount of potassium hydroxide present is about 64 g in order to drill microholes with a diameter of about 50 µm in a polyimide resin film with a thickness of about 50 µm.

4. The process according to any one of claims 1 to 3, **characterized in that** the fastening of the additional layer (5) by bonding comprises the following steps of:
- coating the non-metallized face of the polyimide resin film (6) using a two-stage liquid epoxy adhesive (8) as a layer of uniform thickness as such and curing the adhesive in such a way that the uniform layer of cured adhesive (8) has a thickness approximately equal to at least the thickness of the printed circuits (3, 14) that are present on the receiving face to which the film (6) has to be bonded; and
- vacuum-pressing the layer (5) onto the receiving face under temperature, pressure and time conditions suitable for ensuring uniform bonding of the layer (5).

5. The process according to any one of claims 1 to 4, **characterized in that** the adhesive layer (8) at the bottom of the microholes (9, 11) is removed by spraying sulfuric acid having a concentration of 90 to 100%.

6. The process according to any one of claims 1 to 5, **characterized in that** the additional layer (5) comprises a polyimide resin film (6)covered on one side with a copper film (7) having a thickness of at least 5 µm.

7. The process according to any one of claims 1 to 6, **characterized in that** two additional layers (5) with a metallized external face are intimately joined to the respective two sides of the initially prepared substrate (1).

8. The process according to any one of claims 1 to 7, **characterized in that** at least one other additional layer (5) is also intimately joined to the external face of a layer (5) put into place beforehand and the treatment procedure is repeated on this other layer.

## Patentansprüche

1. Verfahren zur Herstellung eines mehrschichtigen Moduls mit gedruckten Schaltungen hoher Dichte, umfassend die folgenden Schritte:
- Herstellen eines Substrats (1) mit doppelseitig gedruckten Schaltungen (3) mit metallisierten Durchkontakten (4), wobei das Substrat (1) durch Ausführung herkömmlicher Techniken zur Herstellung gedruckter Schaltungen hergestellt wird;
- Festkleben einer zusätzlichen Schicht (5), die aus einer Polyimidharzfolie (6) besteht, deren eine Seite mit einer Metallfolie (7) kaschiert ist, mittels eines flüssigen polymerisierbaren Zweiphasen-Epoxidklebers (8) auf eine Seite des Substrats, wobei die Schicht über die nichtmetallisierte Seite der Folie festgeklebt wird;
- selektives Abziehen der Metallfolie (7) von der zusätzlichen Schicht (5) in einer solchen Weise, dass das Metall an vorbestimmten Stellen, die für die Mikrolöcher (12) vorgesehen sind, gegenüber darunterliegenden metallisierten Zonen des Substrats entfernt wird;
**gekennzeichnet durch** die folgenden Schritte:
- anisotropes chemisches Ätzen von Mikrolöchern (12), die durch die Folie (6) hindurch verlaufen, **durch** Eintauchen der Folie (6) in ein statisches Bad aus einer wässrigen Lösung von Ethylendiamin, die mit Kaliumhydroxid in einer Menge versetzt ist, welche von der Dicke der Polyimidharzfolie (6) und der Querabmessung der Mikrolöcher (12) anhängt, bei einer Temperatur von wenigstens 25 °C und anschließendes Abspülen mit einem Detergens;
- Entfernen der Kleberschicht (8), die am Boden der **durch** die Folie (6) hindurch verlaufenden Mikrolöcher (12) auftritt, **durch** Aufsprühen eines Lösungsmittels, so dass sich die Mikrolöcher (12) zu den darunterliegenden metallisierten Zonen des Substrats (1) hin öffnen;
- Metallisieren der Mikrolöcher (12) in einer solchen Weise, dass ihre Metallisierung in leitendem Kontakt mit den darunterliegenden metallisierten Zonen und mit der äußeren Metallfolie (7) der Schicht (5) steht; und
- selektives Abziehen der Metallfolie (7) unter Bildung von gedruckten Schaltungen (14) in leitender Verbindung mit den metallisierten Mikrolöchern.

2. Verfahren gemäß Anspruch 1, **dadurch gekennzeichnet, dass** das Ätzen der Mikrolöcher (12) durch die Polyimidharzfolie (16) unter Verwendung einer mit Kaliumhydroxid KOH versetzten wässrigen Lösung von einem Drittel Wasser und zwei Dritteln Ethylendiamin pro Liter erfolgt.

3. Verfahren gemäß Anspruch 2, **dadurch gekennzeichnet, dass** das Kaliumhydroxid in einer Menge pro Liter wässriger Lösung von ungefähr 64 g vorhanden ist, um Mikrolöcher mit einem Durchmesser von ungefähr 50 µm in eine Polyimidharzfolie mit einer Dicke von ungefähr 50 µm zu ätzen.

4. Verfahren gemäß einem der Ansprüche 1 bis 3, **dadurch gekennzeichnet, dass** das Festkleben der zusätzlichen Schicht (5) die folgenden Schritte umfasst:
- Bestreichen der nichtmetallisierten Seite der Polyimidharzfolie (6) mit einem flüssigen Zweiphasen-Epoxidkleber (8), der in einer Schicht mit einer solchen gleichmäßigen Dicke ausgebreitet und so polymerisieren gelassen wird, dass die gleichmäßige Schicht des polymerisierten Klebers (8) eine Dicke aufweist, die im Wesentlichen wenigstens gleich der Dicke der gedruckten Schaltungen (3, 14) ist, die sich auf der aufnehmenden Seite befinden, auf die die Folie (6) geklebt werden soll; und
- Pressen der Schicht (5) auf der aufnehmenden Seite im Vakuum unter geeigneten Temperatur- und Druckbedingungen und während einer geeigneten Dauer, um ein gleichmä-βiges Kleben der Schicht (5) zu gewährleisten.

5. Verfahren gemäß einem der Ansprüche 1 bis 4, **dadurch gekennzeichnet, dass** das Entfernen der Kleberschicht (8) am Boden der Mikrolöcher (9, 11) durch Aufsprühen von Schwefelsäure mit einer Konzentration von 90 bis 100% erfolgt.

6. Verfahren gemäß einem der Ansprüche 1 bis 5, **dadurch gekennzeichnet, dass** die zusätzliche Schicht (5) eine Polyimidharzfolie (6) umfasst, die auf einer Seite mit einer Kupferfolie (7) mit einer Dicke von wenigstens 5 µm kaschiert ist.

7. Verfahren gemäß einem der Ansprüche 1 bis 6, **dadurch gekennzeichnet, dass** zwei zusätzliche Schichten (5) mit metallisierter Außenseite jeweils auf den beiden Seiten des anfangs hergestellten Substrats (1) befestigt werden.

8. Verfahren gemäß einem der Ansprüche 1 bis 7, **dadurch gekennzeichnet, dass** außerdem wenigstens eine weitere zusätzliche Schicht (5) auf der Außenseite einer Schicht (5), die zuvor aufgetragen wurde, befestigt wird und das Behandlungsverfahren mit dieser weiteren Schicht wiederholt wird.
